# EUROPEAN PATENT APPLICATION

(11) **EP 4 700 474 A1**
(43) Date of publication of application: **25.02.2026**
(21) Application number: 24195481.7
(22) Date of filing: 20.08.2024
(51) Int. Cl.: G03F 7/00, G03F 9/00

(54) **A METHOD FOR MODELING METROLOGY DATA OVER A SUBSTRATE AREA AND ASSOCIATED APPARATUSES**

(71) Applicant: ASML Netherlands B.V., 5500 AH Veldhoven (NL)
(72) Inventor: BRINKHOF, Ralph, 5500 AH Veldhoven (NL); MEGENS, Henricus, Johannes, Lambertus, 5500 AH Veldhoven (NL); BIJNEN, Franciscus, Godefridus, Casper, 5500 AH Veldhoven (NL)
(74) Representative: ASML Netherlands B.V.

(57) **Abstract**

Disclosed is method for modeling alignment data for exposure of a third layer on a substrate in an exposure process. The method comprises obtaining at least first layer alignment data relating to a first layer and second layer alignment data relating to a second layer; fitting a first model to the first layer alignment data to obtain a first alignment model and fitting a second model to the second layer alignment data to obtain a second alignment model; determining, for each of a plurality of different subsets of model parameters of said first alignment model and second alignment model, a respective weighting for each of said first model and second model; and combining the first model and second model in accordance with said weighting to determine a combined alignment model.

## Description

### FIELD

The present disclosure relates to processing of substrates for the production of, for example, semiconductor devices.

### BACKGROUND

An exposure apparatus (e.g., a lithographic apparatus) is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use radiation. The wavelength of this radiation determines the minimum size of features which can be formed on the substrate. Typical wavelengths currently in use are about 365 nm (i-line), about 248 nm, about 193 nm and about 13 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of about 193 nm.

Low-k1 lithography may be used to process features with dimensions smaller than the classical resolution limit of a lithographic apparatus. In such a process, the resolution formula may be expressed as CD = k1×λ/NA, where A, is the wavelength of radiation employed, NA is the numerical aperture of the projection optics in the lithographic apparatus, CD is the "critical dimension" (generally the smallest feature size printed, but in this case half-pitch) and k1 is an empirical resolution factor. In general, the smaller k1 the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of a numerical aperture (NA,) a customized illumination scheme, use of one or more phase shifting patterning devices, optimization of the design layout such as optical proximity correction (OPC) in the design layout, or other methods generally defined as resolution enhancement techniques (RET). Additionally or alternatively, one or more tight control loops for controlling a stability of the lithographic apparatus may be used to improve reproduction of the pattern at low k1.

Effectiveness of the control of a lithographic apparatus may depend on characteristics of individual substrates. For example, a first substrate processed by a first processing tool prior to processing by the lithographic apparatus (or any other process step of the manufacturing process, herein referred to generically as a manufacturing process step) may benefit from (slightly) different control parameters than a second substrate processed by a second processing tool prior to processing by the lithographic apparatus.

The accurate placement of patterns on the substrate is a chief challenge for reducing the size of circuit components and other products that may be produced by lithography. In particular, the challenge of measuring accurately the features on a substrate which have already been laid down is a critical step in being able to align successive layers of features in superposition accurately enough to produce working devices with a high yield. So-called overlay should, in general, be achieved within a few tens of nanometers in today's sub-micron semiconductor devices, down to a few nanometers in the most critical layers.

Consequently, modern lithography apparatuses involve extensive measurement or 'mapping' operations prior to the step of actually exposing or otherwise patterning the substrate at a target location. So-called advanced alignment models have been and continue to be developed to model and correct more accurately non-linear distortions of the wafer 'grid' that are caused by processing steps and/or by the lithographic apparatus itself. Not all distortions are correctable during exposure, however, and it remains important to trace and eliminate as many causes of such distortions as possible.

These distortions of the wafer grid are represented by metrology data associated with mark position. The metrology data are obtained from measurements of wafers. An example of such measurements are alignment measurements of alignment marks performed using an alignment system in a lithographic apparatus prior to exposure.

It is sometimes desirable to use a different modeling strategy (e.g., different models) for different layers of the same substrate. However, doing this may introduce errors due solely to the different modeling strategies used. It is therefore desirable to improve alignment modeling, for example when different modeling strategies and/or different model parameters are used in different layers.

### SUMMARY

In a first aspect of the invention there is provided a method for modeling alignment data for exposure of a third layer on a substrate in an exposure process, the method comprising: obtaining at least first layer alignment data relating to a first layer and second layer alignment data relating to a second layer; fitting a first model to the first layer alignment data to obtain a first alignment model and fitting a second model to the second layer alignment data to obtain a second alignment model; determining, for each of a plurality of different subsets of model parameters of said first alignment model and second alignment model, a respective weighting for each of said first model and second model; and combining the first model and second model in accordance with said weighting to determine a combined alignment model.

In a further aspect of the invention, there is provided a computer program comprising program instructions operable to perform the method of the first aspect when run on a suitable apparatus, and associated processing apparatus and exposure apparatus.

### BRIEF DESCRIPTION OF THE DRAWINGS

Embodiments of the invention will now be described, by way of example only, with reference to the accompanying schematic drawings, in which:
Figure 1 depicts a schematic overview of a lithographic apparatus;
Figure 2 depicts a schematic overview of a lithographic cell;
Figure 3 shows schematically the use of the lithographic apparatus and lithographic cell of Figures 1 and 2 together with one or more other apparatuses forming a manufacturing facility for, e.g., semiconductor devices, the facility implementing a control strategy according to an embodiment of the invention;
Figure 4(a) schematically depicts the concept of direct alignment;
Figure 4(b) schematically depicts the concept of indirect alignment; and
Figure 5 schematically depicts, conceptually, a weighting method for weighting between a first alignment model and a second alignment model.

### DETAILED DESCRIPTION

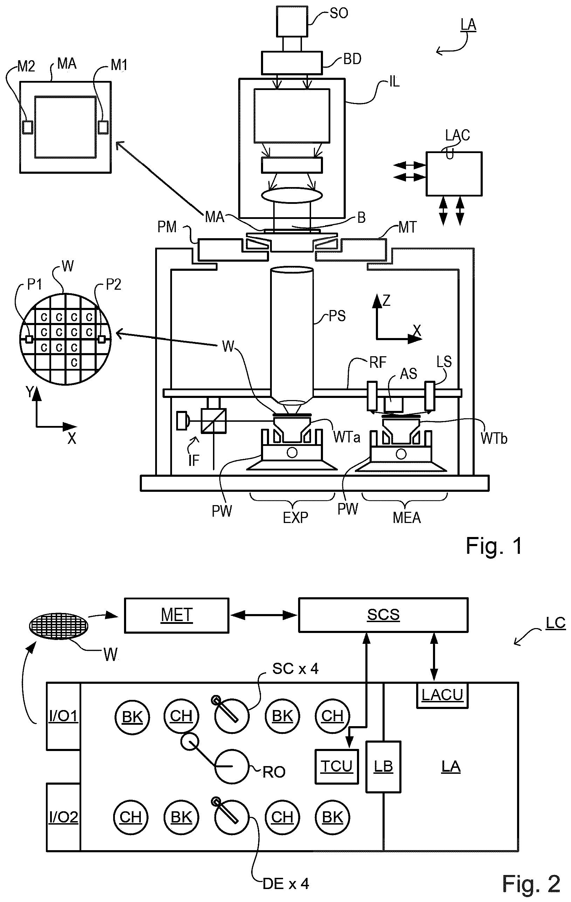

Figure 1 schematically depicts an exposure apparatus or lithographic apparatus LA. The lithographic apparatus LA includes an illumination system (also referred to as illuminator) IL configured to condition a radiation beam B (e.g., UV radiation, DUV radiation or EUV radiation), a support (e.g., a mask table) T constructed to support a patterning device (e.g., a mask) MA and connected to a first positioner PM configured to accurately position the patterning device MA in accordance with certain parameters, one or more substrate supports (e.g., a wafer table) WTa and WTb constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in U.S. Patent No. 6,952,253, which is incorporated herein by reference.

Lithographic apparatus LA in this example is of a so-called dual stage type which has two substrate tables WTa and WTb and two stations - an exposure station and a measurement station-between which the substrate tables can be moved. While one substrate on one substrate table is being exposed at the exposure station EXP, another substrate can be loaded onto the other substrate table at, e.g., the measurement station MEA or at another location (not shown) or can be processed at measurement station MEA. A substrate table with a substrate can be located at measurement station MEA so that various preparatory steps may be carried out. The preparatory steps may include mapping the surface height of the substrate using a level sensor LS and/or measuring the position of alignment marks on the substrate using an alignment sensor AS. Due to inaccuracies in creating the marks and also due to deformations of the substrate that occur throughout its processing, the set of marks may next to translation and rotation have undergone more complex transformations. Consequently, in addition to measuring position and orientation of the substrate, the alignment sensor in practice may measure in detail the positions of many marks across the substrate area, if the apparatus LA is to print product features at the correct locations with high accuracy. The measurement of alignment marks can therefore be time-consuming and the provision of two substrate tables enables a substantial increase in the throughput of the apparatus. If the position sensor IF is not capable of measuring the position of the substrate table while it is at the measurement station as well as at the exposure station, a second position sensor may be provided to enable the positions of the substrate table to be tracked at both stations. An embodiment of the invention can be applied in an apparatus with only one substrate table, or with more than two.

In addition to having one or more substrate supports, the lithographic apparatus LA may comprise a measurement stage (not shown). The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

The radiation beam B is incident on the patterning device (e.g., mask) MA, which is held on the support structure (e.g., mask table) MT, and is patterned by the patterning device. Having traversed the patterning device MA, the radiation beam B passes through the projection system PS, which focuses the beam onto a target portion C of the substrate W. With the aid of the second positioner PW and position sensor IF (e.g. an interferometric device, linear encoder or capacitive sensor), the substrate table WTa/WTb can be moved accurately, e.g. so as to position different target portions C in the path of the radiation beam B. Similarly, the first positioner PM and another position sensor (which is not explicitly depicted in Figure 1) can be used to accurately position the patterning device MA with respect to the path of the radiation beam B, e.g. after mechanical retrieval from a mask library, or during a scan. In general, movement of the support structure MT may be realized with the aid of a long-stroke module (coarse positioning) and a short-stroke module (fine positioning), which form part of the first positioner PM. Similarly, movement of the substrate table WTa/WTb may be realized using a long-stroke module and a short-stroke module, which form part of the second positioner PW. In the case of a stepper (as opposed to a scanner) the support structure MT may be connected to a short-stroke actuator only, or may be fixed. Patterning device MA and substrate W may be aligned using patterning device alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device MA, the patterning device alignment marks may be located between the dies.

The apparatus further includes a lithographic apparatus control unit LACU which controls all the movements and measurements of various actuators and sensors of the lithographic apparatus (such as those described). Control unit LACU also includes signal processing and data processing capacity to implement desired calculations relevant to the operation of the apparatus. In practice, control unit LACU will be realized as a system of many sub-units, each handling the real-time data acquisition, processing and control of a subsystem or component within the apparatus. For example, one processing subsystem may be dedicated to servo control of the substrate positioner PW. Separate units may even handle coarse and fine actuators, or different axes. Another unit might be dedicated to the readout of the position sensor IF. Overall control of the apparatus may be controlled by a central processing unit, communicating with these sub-systems processing units, with operators and with other apparatuses involved in the lithographic manufacturing process.

As shown in Figure 2 the lithographic apparatus LA may form part of a lithographic cell LC, also sometimes referred to as a lithocell or (litho)cluster, which often also includes apparatuses to perform pre- and post-exposure processes on a substrate W. Conventionally these apparatuses includes one or more spin coaters SC to deposit resist layers, one or more developers DE to develop exposed resist, one or more chill plates CH and one or more bake plates BK, e.g. for conditioning the temperature of substrates W e.g. for conditioning solvents in the resist layers. A substrate handler, or robot, RO picks up substrates W from input/output ports I/O1, I/O2, moves them between the different processing apparatuses and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, one or more inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus MET, which may also be referred to as a metrology apparatus or metrology tool, is used to determine one or more properties of the substrates W, and in particular, how one or more properties of different substrates W vary or how one or more properties associated with different layers of the same substrate W vary from layer to layer. The inspection apparatus may be constructed to identify defects on the substrate W and may, for example, be part of the lithocell LC, or may be integrated into the lithographic apparatus LA, or may even be a stand-alone device. The inspection apparatus may measure the one or more properties on a latent image (an image in a resist layer after the exposure), or on a semi-latent image (an image in a resist layer after a post-exposure bake step), or on a developed resist image (in which the exposed or unexposed parts of the resist have been removed), or even on an etched image (after a pattern transfer step such as etching).

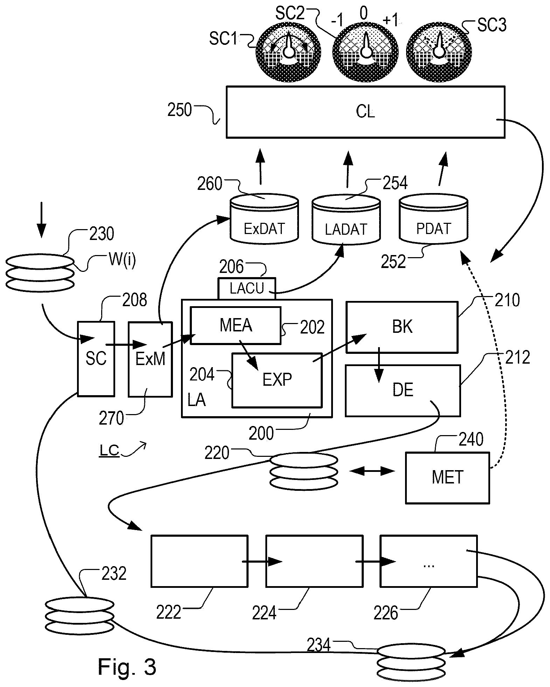

Figure 3 shows the lithographic apparatus LA and the lithocell LC in the context of an industrial manufacturing facility for, e.g., semiconductor products. Within the lithographic apparatus (or "litho tool" 200 for short), the measurement station MEA is shown at 202 and the exposure station EXP is shown at 204. The control unit LACU is shown at 206. As already described, litho tool 200 forms part of a "litho cell" or "litho cluster" that also includes a coating apparatus SC, 208 for applying photosensitive resist and/or one or more other coatings to substrate W for patterning by the apparatus 200. At the output side of apparatus 200, a baking apparatus BK, 210 and developing apparatus DE, 212 are provided for developing the exposed pattern into a physical resist pattern. Other components shown in Figure 3 are omitted, for clarity.

Once the pattern has been applied and developed, patterned substrates 220 are transferred to other processing apparatuses such as are illustrated at 222, 224, 226. A wide range of processing steps are implemented by various apparatuses in a typical manufacturing facility. For the sake of example, apparatus 222 in this embodiment is an etching station, and apparatus 224 performs a post-etch annealing step. Further physical and/or chemical processing steps are applied in further apparatuses, 226, etc. Numerous types of operation can be required to make a real device, such as deposition of material, modification of surface material characteristics (oxidation, doping, ion implantation etc.), chemical-mechanical polishing (CMP), and so forth. The apparatus 226 may, in practice, represent a series of different processing steps performed in one or more apparatuses.

The described semiconductor manufacturing process comprising a sequence of patterning process steps is just one example of an industrial process in which the techniques disclosed herein may be applied. The semiconductor manufacturing process includes a series of patterning steps. Each patterning process step includes a patterning operation, for example a lithographic patterning operation, and a number of other chemical and/or physical operations.

The manufacture of semiconductor devices involves many repetitions of such processing, to build up device structures with appropriate materials and patterns, layer-by-layer on the substrate. Modern device manufacturing processes may comprise 40 or 50 individual patterning steps, for example. Accordingly, substrates 230 arriving at the litho cluster may be newly prepared substrates, or they may be substrates that have been processed previously in this cluster 232 or in another apparatus entirely. Similarly, depending on the required processing, substrates on leaving apparatus 226 may be returned for a subsequent patterning operation in the same litho cluster (such as substrates 232), they may be destined for patterning operations in a different cluster (such as substrates 234), or they may be finished products to be sent for dicing and packaging (such as substrates 234).

Each layer of the product structure typically involves a different set of process steps, and the apparatuses used at each layer may be completely different in type. Further, even where the processing steps to be applied by the apparatuses are nominally the same, in a large facility, there may be several supposedly identical machines working in parallel to perform the processing on different substrates. Small differences in set-up or faults between these machines can mean that they influence different substrates in different ways. Even steps that are relatively common to each layer, such as etching (apparatus 222) may be implemented by several etching apparatuses that are nominally identical but working in parallel to maximize throughput. Parallel processing may also be performed in different chambers within a larger apparatus. Moreover, in practice, different layers often involve different etch processes, for example chemical etch, plasma etch, etc., according to the details of the material to be etched, and special requirements such as, for example, anisotropic etching.

The previous and/or subsequent processes may be performed in other lithography apparatuses, as just mentioned, and may even be performed in different types of lithography apparatus. For example, one or more layers in the device manufacturing process which are very demanding in terms of, e.g., resolution and/or overlay may be performed in a more advanced lithography tool than one or more other layers that are less demanding. Therefore, one or more layers may be exposed in an immersion type lithography tool, while one or more others are exposed in a `dry' tool. One or more layers may be exposed in a tool working at DUV wavelengths, while one or more others are exposed using EUV wavelength radiation.

Also shown in Figure 3 is the metrology apparatus (MET) 240 which is provided for making measurements of parameters of the products at desired stages in the manufacturing process. A common example of a metrology station in a modern lithographic manufacturing facility is a scatterometer, for example an angle-resolved scatterometer or a spectroscopic scatterometer, and it may be applied to measure one or more properties of developed substrates at 220 prior to etching in the apparatus 222. Using metrology apparatus 240, performance parameter data PDAT 252 may be determined. From this performance parameter data PDAT 252, it may be further determined that a performance parameter, such as overlay or critical dimension (CD), does not meet specified accuracy requirements in the developed resist. Prior to the etching step, the opportunity exists to strip the developed resist and reprocess one or more of the substrates 220 through the litho cluster. Moreover, the metrology results from the metrology apparatus 240 can be used to maintain accurate performance of the patterning operations in the litho cluster, by making small adjustments over time, thereby reducing or minimizing the risk of products being made out-of-specification, and requiring re-work. Of course, metrology apparatus 240 and/or one or more other metrology apparatuses (not shown) can be applied to measure one or more properties of the processed substrates 232, 234, and/or of incoming substrates 230.

Typically the patterning process in a lithographic apparatus LA is one of the most significant steps in the processing which involves high accuracy of dimensioning and placement of structures on the substrate W. To help ensure this high accuracy, three systems may be combined in a control environment as schematically depicted in Figure 3. One of these systems is the litho tool 200 which is (virtually) connected to a metrology apparatus 240 (a second system) and to a computer system CL 250 (a third system). A desire of such an environment is to optimize or improve the cooperation between these three systems to enhance an overall so-called "process window" and provide one or more tight control loops to help ensure that the patterning performed by the lithographic apparatus LA stays within a process window. The process window defines a range of values of a plurality of process parameters (e.g. two or more selected from dose, focus, overlay, etc.) within which a specific manufacturing process yields a defined result (e.g. a functional semiconductor device) - typically a range within which the values of the process parameters in the lithographic process or patterning process are allowed to vary while yielding a proper structure (e.g., specified in terms of an acceptable range of CD (such as +- 10% of a nominal CD)).

The computer system CL may use (part of) the design layout to be patterned to predict which one or more resolution enhancement techniques to use and to perform computational lithography simulations and calculations to determine which patterning device layout and lithographic apparatus settings achieve a largest overall process window of the patterning process (depicted in Figure 3 by the double arrow in the first dial SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Figure 3 by the arrow pointing "0" in the second dial SC2).

The metrology tool MET may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third dial SC3).

Computer system 250 can implement control of the process based on a combination of (i) "pre-processing metrology data" (e.g., including scanner metrology data LADAT 254, and External pre-processing metrology ExDAT 260), associated with substrates before they are processed in a given processing step (for example a lithography step) and (ii) performance data or "post-processing data" PDAT 252 that is associated with the substrates after they have been processed.

A first set of pre-processing metrology data LADAT 254 (referred to herein as scanner metrology data, as it is data generated by the lithographic apparatus LA 200 or scanner) may comprise the alignment data conventionally obtained by the lithographic apparatus LA 200 using alignment sensor AS in the measurement station 202. Alternatively, or in addition to the alignment data, the scanner metrology data LADAT 254 may include height data obtained using level sensor LS, and/or "wafer quality" signals from the alignment sensor AS or the like. As such, the scanner metrology data LADAT 254 may comprise an alignment grid for the substrate, and data relating to substrate deformation (flatness). For example, the scanner metrology data LADAT 254 may be generated by the measurement station MEA 202 of twin stage lithographic apparatus LA 200 (e.g., as this typically comprises the alignment sensor and leveling sensor) in advance of exposure, enabling simultaneous measurement and exposure operations. Such twin stage lithographic apparatus are well known.

Increasingly, (e.g. stand-alone) external pre-exposure metrology tools ExM 270 are used to make measurements before exposure on a lithographic apparatus. Such external pre-exposure metrology tools ExM 270 are distinct from the measurement station MEA 202 of a twin stage lithographic apparatus LA 200. Any pre-exposure measurements performed within the track are also considered to be external measurements. To maintain exposure throughput at a sufficient level, the scanner metrology data LADAT (e.g., alignment grid and substrate deformation grid) measured by measurement station MEA 202 is based on a sparser set of measurements as would be desirable. This typically means such a measurement station is incapable of gathering sufficient metrology data for higher order corrections, and particularly corrections beyond the third order. In addition to this, use of an opaque hard mask can make it difficult to accurately measure the wafer grid in alignment.

External pre-exposure metrology tools ExM 270 enable much denser measurements to be made on each substrate, prior to exposure. Some of these pre-exposure metrology tools ExM 270 measure and/or predict wafer grid deformation at a throughput equal to or faster than the scanner, and with a measurement density much higher than can be achieved using an alignment sensor and level sensor, even when such sensors are comprised within a separate measurement station MEA 202. Pre-exposure metrology tools comprise, for example, substrate shape inspection tools and/or stand-alone alignment stations.

While Figure 3 shows separate storage 252, 254, 260 for each of the performance data PDAT, scanner metrology data LADAT and external pre-exposure data ExDAT, it will be appreciated that these different types of data may be stored in one common storage unit, or may be distributed over a larger number of storage units, from which particular items of data can be retrieved when required.

To represent alignment measurements over a wafer and/or over a field, an alignment model is used. A first purpose of an alignment model is to provide a mechanism for interpolating and/or extrapolating the available measurements data over the whole wafer, such that an expose grid can be created on each exposure field. Most present alignment metrology data is sparse as it is simply not practical to measure as many measurement regions as would be desirable from an overlay accuracy perspective: the time and therefore throughput overhead would be too high. A second purpose of an alignment model is to provide noise suppression. This may be achieved by using fewer model parameters than measurements or by using regularization.

While standard interfield models (e.g., linear interfield models) might use fewer than ten parameters (e.g., 6 parameters), advanced or higher order interfield alignment models may use more than 10 parameters, more than 15 parameters, or more than 30 parameters. Examples of advanced interfield models are higher order wafer alignment (HOWA) models and radial basis function (RBF) based alignment models. HOWA is a published technique based on second and higher order polynomial functions. The order number may vary, e.g., it may be second order or higher, third order or higher, fourth order or higher, fifth order or higher etc.. RBF modeling is described in US2012218533A1, which is incorporated herein by reference. Different versions and extensions of these advanced models can be devised (e.g., different modeling orders for HOWA or different regularization for RBF). The advanced models generate a complex description of the wafer grid that is corrected for, during the exposure of the target layer. RBF and latest versions of HOWA provide particularly complex descriptions based on tens of parameters. This implies many measurements are required to obtain a wafer grid with sufficient accuracy. Each of these interfield models may be additionally combined with an intrafield model.

Alignment can be made to any preceding layer. For example, a layer being exposed may be aligned to any previously exposed layer in which alignment marks have been exposed. Being aligned to a previously exposed layer described measuring alignment marks in that previously exposed layer and determining (and implementing) corresponding positional corrections for the layer being exposed, which correct for grid distortions in the previously exposed layer so as to minimize a performance indicator such as overlay error.

In particular, alignment strategies may include direct alignment, where the layer being exposed is directly aligned to the layer with respect to which overlay is critical, and indirect alignment, where the two layers between which overlay is critical are each aligned to another common layer.

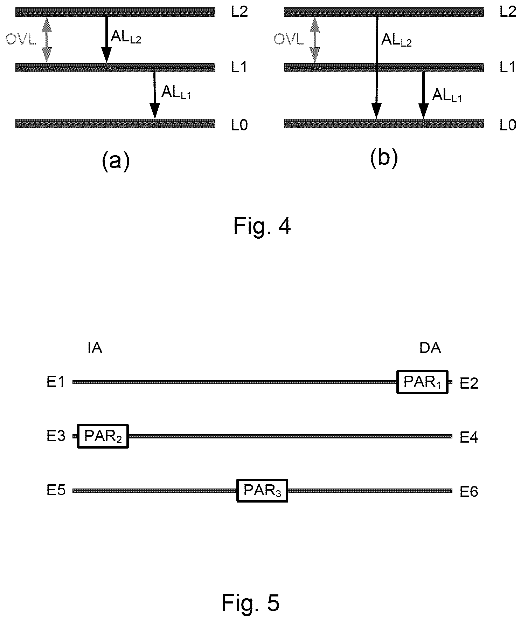

Figure 4(a) schematically illustrates direct alignment and Figure 4(b) schematically illustrates indirect alignment. In each case, three layers are shown, a lower layer L0, a top layer or layer just exposed L1 and a layer to be exposed L2. There may (or may not) be additional layers (not shown) between layer L0 and layer L1. The critical overlay OVL, i.e., an important overlay for which tolerance to any overlay error is small (e.g., for which the process window is small) is the overlay between layer L2 and layer L1.

In direct alignment, e.g., as illustrated by Figure 4(a), the layer being exposed L2 may be aligned to the layer L1 for which the overlay OVL between the layers L2-L1 is critical. When layer L1 was exposed, it was aligned to layer L0 (or an intervening layer, e.g., the layer immediately below L1 if there are intervening layers) and layer L2 is aligned to layer L1. In indirect alignment, e.g., as illustrated by Figure 4(b), both layer L1 and layer L2 are aligned to a common lower layer, in this example lower layer L0.

Direct alignment and indirect alignment each have inherent respective advantages and disadvantages, and as such, neither will always be the better strategy in all cases. These advantages and disadvantages depend on the source of the error that it being corrected for and the quality of the alignment marks.

In the case of direct alignment, aligning to top layers is often compromised by process impact errors such as mark print errors and/or mark deformation which may result in mark asymmetry. Because the marks measured in aligning each of the critical layers (e.g., layers L1 and L2) are different (each layer is aligned to a respective different layer) there is no cancellation of the process impact. Additionally the marks in the top layer may be subject to larger process errors than marks in lower layers, although this is balanced by the top layer marks providing better detectability (better signal-to-noise).

Direct alignment has the advantage that the layer being exposed is being aligned to the layer with respect to which overlay is critical. Therefore, exposure errors which contribute to the overall performance (e.g., overlay error) result only from the exposure of layer being exposed (e.g., layer L2). These exposure errors may comprise one or more of: errors due to measuring/reading of the alignment marks during the exposure (e.g., mark repro error), actual exposure errors (positional and/or imaging errors in the actual exposure of the layer) and alignment errors due to contamination. Such contamination may comprise, for example, a dust particle on the wafer or between wafer and burl of the wafer table or clamp being used to hold the wafer.

By contrast, essentially the reverse is true for the indirect alignment case. Indirect alignment is compromised by not providing a direct measurement of the layer to which overlay is critical. This means that the exposure errors resultant from exposure of the layer with respect to which overlay is critical (e.g., layer L1) also contributes to the overlay error, in addition to exposure errors of the layer being exposed. Because of this, complicated overlay feed forwards, or even overlay based rework, may be required to solve the mismatches. However, if both layers between which overlay is critical are aligning to the same underlying layer, the overlay becomes insensitive to mark print errors in the alignment marks and less sensitive to mark deformation effects, as these effectively cancel, at least in part.

It is proposed going forward to measure more alignment marks prior to each exposure. This is being made possible, without significantly and/or unacceptably affecting throughput or productivity, by new proposed alignment sensor technologies such as multi-sensor head alignment sensors capable of measuring multiple marks simultaneously and/or by much faster scanning over marks resulting in little or no additional measurement time to measure two neighboring marks from different layers. Alternatively or in addition, standalone alignment metrology stations are presently used which can measure dense alignment mark schemes. It is proposed that such technologies will make practical the measurement of multiples of the number of marks presently measured.

It is proposed herein to determine a combined alignment model for exposure of a third layer, the method comprising obtaining first layer alignment data and second layer alignment data (e.g., by measuring alignment marks from at least a first layer to obtain first layer alignment data and a second layer to obtain second layer alignment data); fitting a first model to the first layer alignment data to obtain a first alignment model and a second model to the second layer alignment data to obtain a second alignment model; determining, for each of a plurality of different subsets of model parameters of said first alignment model and second alignment model, a respective weighting for each of said first model and second model; and combining the first model and second model in accordance with said weighting to determine a combined alignment model. The combined alignment model may be used for determining the positional corrections for the exposure of the third layer. The method may further comprise exposing the third layer in accordance with the positional corrections.

The first layer may comprise the layer with respect to which the second layer was aligned to when it was exposed. The second layer may comprise a layer with respect to which overlay is critical for the third layer. The second layer may, for example, comprise the present topmost layer (e.g., the layer last exposed). Weighting in favor of the first alignment model effectively weights in favor of an indirect alignment strategy for a particular subset of model parameters, while weighting in favor of the second alignment model effectively weights in favor of a direct alignment strategy for the particular subset of model parameters. The weighting may be binary (e.g., selecting one or other of the alignment models for each subset of parameters) or more continuous, allowing for a balancing of the modeling strategies for each subset.

The plurality of subsets of model parameters may comprise different model order subsets (e.g., proper subsets), each said model order subset comprising model parameters of a respective one or more model orders. for example, a first subset may comprise linear model parameters and at least a second subset may comprise higher order model parameters of one or more higher model orders (e.g., orders of two or more). Alternatively or in addition, the plurality of subsets of model parameters may comprise one or more interfield subsets versus one or more intrafield subsets of model parameters. In a specific example, the subsets of model parameters may comprise a first subset comprising interfield first order (linear) model parameters, a second subset comprising interfield higher order model parameter and a third subset comprising intrafield model parameters. However, other model subsets can be envisaged, e.g., defining subsets respectively for linear and higher order intrafield model parameters, and/or defining respective different subsets for one or more different orders of the higher order parameters. Interfield and intrafield may further be generalized to inter-region and intra-region, i.e., where the modeling may be done at a different scale to field-level modeling (e.g., sub-field modeling for stitched fields). One or more subsets may comprise a respective different single model parameter. For example, a weighting per model parameter may be implemented by each subset comprising only a respective different single model parameter. Another type of model that can be combined with inter and intra-field models are `edge models' that model the radial distortion near the edge of the wafer, that are caused by the edge roll off beyond the last wafer burl. The edge roll off is affected by the warp of the wafer prior to clamping, which in its turn is caused by the stress induced by the layer stack on the wafer. Since this layer stack is different for each exposure layer, the edge roll can vary from wafer to wafer. As a result it is generally better to base the edge model parameters on the layer to which overlay is critical, or layer that has very similar edge roll off compared to that layer. In addition mark deformation effects are typically higher towards the edge of the wafer, and it is best to align to layer with minimal mark deformation.

It can be appreciated that the optimal weighting per parameter subset may differ depending on the source and/or type of the error; e.g., the magnitude of different error sources or types. The different error sources may comprise, for example process impact errors and exposure errors. More specifically, process impact errors may comprise, for example, one or more of *inter alia*: mark print errors and/or mark deformation errors, interfield print errors, imaging induced print errors, process sensitivity errors. Exposure errors may comprise, for example, one or more of *inter alia*: errors due to measuring/reading of the alignment marks during the exposure (e.g., mark repro error), actual exposure errors (positional and/or imaging errors in the actual exposure of the layer) and alignment errors due to contamination. Another error source category example may comprise errors resulting from differences of tools used to expose the different layers. By way of example, if one layer was exposed on a different machine suffering from e.g., a wafer load impact then the weighting of the parameters describing (e.g., at least a part of the) load offset impact may be varied between the layers. Also, one layer may be exposed on a different system which has scan-up-scan-down offset error leading to intrafield translation errors. As such, relevant intrafield information (e.g., scan-up-scan-down status) could be taken from the layer on which such content was introduced, as could, for example wafer deformation by clamping the wafer.

Figure 5 conceptually illustrates the proposed concept for determining an alignment strategy for exposure of a third layer. The model parameters of a first alignment model and a second alignment model are divided into model parameter subsets: intrafield parameters PAR₁ , linear interfield parameters PAR₂ and higher order interfield parameters PAR₃. At least some of these model parameters may be common for the first alignment model and a second alignment model. In many cases, the first and second models fitted to the respective layers will be of the same type (i.e., such that the first and second models each comprise the same model parameters and therefore describe the alignment data of the respective layers in terms of the same model parameters). However, this is not necessarily the case and does not need to be. By way of example, models of different orders (e.g., a third order model and fifth order model) may respectively be fitted to the two layers. In such a case, the weighting may be applied to respective common subsets: e.g., a weighing to the first order interfield parameter subset, a weighting to second and/or third order interfield parameter subset and a weighting to the intrafield parameter subset.

The first alignment model may comprise an alignment model fitted to indirect alignment IA measurements (i.e., first layer measurements) and the second alignment model may comprise an alignment model fitted to direct alignment DA measurements (i.e., second layer measurements). The first layer may be a lower layer, e.g., the layer to which the second layer was aligned, while the critical overlay may be the overlay between the third layer and second layer.

The optimal weighting ratio per model parameter subset depends on the magnitude of certain error sources E1-E6, with the ratio being conceptually indicated by the position of the parameter label PAR₁, PAR₂, PAR₃ on its respective line between the extremes of a pure indirect alignment IA strategy (indicating a weighting of 100% for the first model and zero percent for the second model) and a pure direct alignment DA strategy (indicating a weighting of 100% for the second model and zero percent for the first model).

For example, for the intrafield parameter subset PAR₁, if the first layer contains large exposure errors and these can be measured accurately with the alignment marks, direct alignment (second alignment model) may be assigned the largest weight, whereas if the marks are sensitive to imaging induced mark print errors, indirect alignment (first alignment model) may be assigned the largest weight. Since the error sources for different model components are different, the optimal ratio between direct and indirect alignment will likely differ per model component.

By way of the simplified illustrative example of Figure 5, the intrafield model parameter subset PAR₁ may be weighted in favor of direct alignment (first fitted model), the linear interfield model parameter subset PAR₂ may be weighted in favor of indirect alignment (second fitted model) and the higher order interfield model parameter subset PAR₃ may have a balanced weighting between a direct alignment and indirect alignment strategy (e.g., between the first fitted model and second fitted model).

The weightings per parameter subset can either be determined based on experience or process knowledge of the user, and/or using a setup tool which determines the optimal ratios, for example, the setup tool may determine the ratios by minimizing a certain performance indicator, such as measured overlay variation or stack-based process simulations. Other performance indicators that such a setup tool may use (e.g., alternatively or in addition) may comprise one or more of: noise (e.g., repro or wafer quality) and process accuracy (e.g., *inter alia* color to color variation, polarization to polarization variation, intensity asymmetry strength). For example, a weighing per subset of model parameters may be determined by simulating the resulting overlay for different variations of weight combination and selecting the weights that result in the smallest overlay (or more generally optimizes a performance indicator).

Using the simplified illustrative example of Figure 5, the error sources E1-E6 may be considered in terms of error source pairs E1-E2; E3-E4; E5-E6, wherein each of the labels E1-E6 represents respectively at least one process impact error E1, E3, E5 and at least one exposure error E2, E4, E6. The weighting for a particular model parameter subset may have been chosen based on the actual error sources represented by each exposure error pair and the respective magnitude of each of the error sources. As such, the intrafield model parameter subset PAR₁ may be weighted in favor of direct alignment because the exposure error source E2 (e.g., actual exposure error) is dominant with respect to the process impact error E1 (e.g., an imaging induced print error). Similarly, the interfield linear model parameter subset PAR₂ may be weighted in favor of indirect alignment because the process impact error E3 (e.g., process sensitivity) is dominant with respect to the exposure error source E4 (e.g., layer L1 contamination), while interfield linear model parameter subset PAR₃ may have a balanced weighting applied because the process impact error E5 (e.g., interfield print errors) and exposure error source E6 (e.g., layer L1 contamination) have a substantially similar impact.

By way of a specific example of combining the model parameter subsets, an example parameter subset may comprise four linear parameters (e.g., Mag, Rot, TransX and TransY). Each of these model parameters will (usually) have a different value or coefficient assigned thereto as measured (e.g., when fitted to the alignment data of each respective layer). The combined model will comprise a weighted combination of these values for each of the four linear parameters.

While the above discussion describes weighting between two different alignment models obtained from two layers, the concepts may be extended to a determining a per-parameter subset weighting to respectively weigh three or more different alignment models, each modeling alignment data from a respective different layer.

In conjunction with measured data from different layers in the wafer stack, it is proposed that information from previous measurements on the same wafers may be reused. For example, the difference between current and previous measurements on the same alignment marks may be used to weigh and/or regularize the different alignment datasets. For example, at least a high order component of the previous layer model may be forwarded and used to determine a model of the present layer. This may be the case, for example where the previous layer is modeled using a higher order model than the present layer.

To aid implementation of the proposed method, it is further proposed, in an embodiment, to position and measure alignment marks of different layers such that they are non-overlapping. For example, to position and measure respective alignment marks of different layers adjacently (i.e., side-by-side), e.g., for at least the first layer and second layer as has been defined. Alignment marks in different layers which are positioned adjacently may be measured in the same scan direction. As such, first alignment marks in the first layer and second alignment marks in the second layer may be arranged as adjacent pairs of alignment marks, each adjacent pair comprising one of said first alignment marks positioned substantially adjacent (i.e., in the substrate plane) to one of said second alignment marks.

This approach may require an increased scan length. Optionally, this can be compensated by increasing the scan speed to minimize or reduce any time penalty.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.. In that regard, the processed "substrates" may be semiconductor wafers, or they may be other substrates, according to the type of product being manufactured.

Although specific reference may be made in this text to embodiments of the invention in the context of a lithographic apparatus, embodiments of the invention may be used in other apparatus. Embodiments of the invention may form part of a patterning device inspection apparatus, a metrology apparatus, or any apparatus that measures or processes an object such as a wafer (or other substrate) or a mask (or other patterning device). These apparatuses may be generally referred to as lithographic tools. Such a lithographic tool may use vacuum conditions or ambient (non-vacuum) conditions.

In the present document, the terms "radiation" and "beam" are used to encompass all types of radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. Besides the classic mask (transmissive or reflective, binary, phase-shifting, hybrid, etc.), examples of other such patterning devices include a programmable mirror array and a programmable LCD array.

Although specific reference may have been made above to the use of embodiments of the invention in the context of optical lithography, it will be appreciated that the invention, where the context allows, is not limited to optical lithography and may be used in other applications, for example imprint lithography.

The terms "optimizing" and "optimization" as used herein refers to or means adjusting an apparatus (e.g., a lithography apparatus), a process, etc. such that results and/or processes have more desirable characteristics, such as higher accuracy of projection of a design pattern on a substrate, a larger process window, etc. Thus, the term "optimizing" and "optimization" as used herein refers to or means a process that identifies one or more values for one or more parameters that provide an improvement, e.g. a local optimum, in at least one relevant metric, compared to an initial set of one or more values for those one or more parameters. "Optimum" and other related terms should be construed accordingly. In an embodiment, optimization steps can be applied iteratively to provide further improvements in one or more metrics.

Aspects of the invention can be implemented in any convenient form. For example, an embodiment may be implemented by one or more appropriate computer programs which may be carried on an appropriate carrier medium which may be a tangible carrier medium (e.g. a disk) or an intangible carrier medium (e.g. a communications signal). Embodiments of the invention may be implemented using suitable apparatus which may specifically take the form of a programmable computer running a computer program arranged to implement a method as described herein.

In block diagrams, illustrated components are depicted as discrete functional blocks, but embodiments are not limited to systems in which the functionality described herein is organized as illustrated. The functionality provided by each of the components may be provided by software or hardware modules that are differently organized than is presently depicted, for example such software or hardware may be intermingled, conjoined, replicated, broken up, distributed (e.g. within a data center or geographically), or otherwise differently organized. The functionality described herein may be provided by one or more processors of one or more computers executing code stored on a tangible, non-transitory, machine readable medium. In some cases, third party content delivery networks may host some or all of the information conveyed over networks, in which case, to the extent information (e.g., content) is said to be supplied or otherwise provided, the information may be provided by sending instructions to retrieve that information from a content delivery network.

Unless specifically stated otherwise, as apparent from the discussion, it is appreciated that throughout this specification discussions utilizing terms such as "processing," "computing," "calculating," "determining" or the like refer to actions or processes of a specific apparatus, such as a special purpose computer or a similar special purpose electronic processing/computing device.

The reader should appreciate that the present application describes several inventions. Rather than separating those inventions into multiple isolated patent applications, these inventions have been grouped into a single document because their related subject matter lends itself to economies in the application process. But the distinct advantages and aspects of such inventions should not be conflated. In some cases, embodiments address all of the deficiencies noted herein, but it should be understood that the inventions are independently useful, and some embodiments address only a subset of such problems or offer other, unmentioned benefits that will be apparent to those of skill in the art reviewing the present disclosure. Due to costs constraints, some inventions disclosed herein may not be presently claimed and may be claimed in later filings, such as continuation applications or by amending the present claims. Similarly, due to space constraints, neither the Abstract nor the Summary sections of the present document should be taken as containing a comprehensive listing of all such inventions or all aspects of such inventions.

It should be understood that the description and the drawings are not intended to limit the present disclosure to the particular form disclosed, but to the contrary, the intention is to cover all modifications, equivalents, and alternatives falling within the spirit and scope of the inventions as defined by the appended claims.

Modifications and alternative embodiments of various aspects of the inventions will be apparent to those skilled in the art in view of this description. Accordingly, this description and the drawings are to be construed as illustrative only and are for the purpose of teaching those skilled in the art the general manner of carrying out the inventions. It is to be understood that the forms of the inventions shown and described herein are to be taken as examples of embodiments. Elements and materials may be substituted for those illustrated and described herein, parts and processes may be reversed or omitted, certain features may be utilized independently, and embodiments or features of embodiments may be combined, all as would be apparent to one skilled in the art after having the benefit of this description. Changes may be made in the elements described herein without departing from the spirit and scope of the invention as described in the following claims. Headings used herein are for organizational purposes only and are not meant to be used to limit the scope of the description.

As used throughout this application, the word "may" is used in a permissive sense (i.e., meaning having the potential to), rather than the mandatory sense (i.e., meaning must). The words "include", "including", and "includes" and the like mean including, but not limited to. As used throughout this application, the singular forms "a," "an," and "the" include plural referents unless the content explicitly indicates otherwise. Thus, for example, reference to "an" element or "a" element includes a combination of two or more elements, notwithstanding use of other terms and phrases for one or more elements, such as "one or more." The term "or" is, unless indicated otherwise, non-exclusive, i.e., encompassing both "and" and "or." Terms describing conditional relationships, e.g., "in response to X, Y," "upon X, Y,", "if X, Y," "when X, Y," and the like, encompass causal relationships in which the antecedent is a necessary causal condition, the antecedent is a sufficient causal condition, or the antecedent is a contributory causal condition of the consequent, e.g., "state X occurs upon condition Y obtaining" is generic to "X occurs solely upon Y" and "X occurs upon Y and Z." Such conditional relationships are not limited to consequences that instantly follow the antecedent obtaining, as some consequences may be delayed, and in conditional statements, antecedents are connected to their consequents, e.g., the antecedent is relevant to the likelihood of the consequent occurring. Statements in which a plurality of attributes or functions are mapped to a plurality of objects (e.g., one or more processors performing steps A, B, C, and D) encompasses both all such attributes or functions being mapped to all such objects and subsets of the attributes or functions being mapped to subsets of the attributes or functions (e.g., both all processors each performing steps A-D, and a case in which processor 1 performs step A, processor 2 performs step B and part of step C, and processor 3 performs part of step C and step D), unless otherwise indicated. Further, unless otherwise indicated, statements that one value or action is "based on" another condition or value encompass both instances in which the condition or value is the sole factor and instances in which the condition or value is one factor among a plurality of factors. Unless otherwise indicated, statements that "each" instance of some collection have some property should not be read to exclude cases where some otherwise identical or similar members of a larger collection do not have the property, i.e., each does not necessarily mean each and every. References to selection from a range includes the end points of the range.

In the above description, any processes, descriptions or blocks in flowcharts should be understood as representing modules, segments or portions of code which include one or more executable instructions for implementing specific logical functions or steps in the process, and alternate implementations are included within the scope of the exemplary embodiments of the present advancements in which functions can be executed out of order from that shown or discussed, including substantially concurrently or in reverse order, depending upon the functionality involved, as would be understood by those skilled in the art.

Aspects of the invention are set out in the clauses below.
1. A method for modeling alignment data for exposure of a third layer on a substrate in an exposure process, the method comprising: obtaining at least first layer alignment data relating to a first layer and second layer alignment data relating to a second layer; fitting a first model to the first layer alignment data to obtain a first alignment model and fitting a second model to the second layer alignment data to obtain a second alignment model; determining, for each of a plurality of different subsets of model parameters of said first alignment model and second alignment model, a respective weighting for each of said first model and second model; and combining the first model and second model in accordance with said weighting to determine a combined alignment model.
2. A method according to clause 1, wherein the first layer comprises a layer with respect to which the second layer was aligned to when it was exposed.
3. A method according to clause 1 or 2, wherein the second layer comprises a or another layer with respect to which overlay is critical for the third layer.
4. A method according to clause 1, 2 or 3 wherein the second layer comprises the layer last exposed (a last exposed layer) prior to exposure of the third layer.
5. A method according to any preceding clause, wherein the plurality of subsets of model parameters comprises different model order subsets each said model order subset comprising model parameters of a respective different model orders or groups of model orders.
6. A method according to clause 5, wherein a first subset of said plurality of subsets of model parameters comprises linear model parameters and at least a second subset comprises higher order model parameters of one or more higher model orders.
7. A method according to any preceding clause, wherein said plurality of subsets of model parameters comprises one or more inter-region subsets and one or more intra-region subsets of model parameters.
8. A method according to any preceding clause, wherein said plurality of subsets of model parameters comprises one or more interfield subsets and one or more intrafield subsets of model parameters.
9. A method according to any preceding clause, wherein said plurality of subsets of model parameters comprises a first subset comprising interfield first order model parameters, a second subset comprising interfield higher order model parameter and a third subset comprising intrafield model parameters.
10. A method according to any preceding clause, wherein one or more subsets of said plurality of subsets of model parameters comprises only a respective different single model parameter.
11. A method according to any preceding clause, wherein the respective weighting per subset of model parameters is determined in dependence on an error source and/or a magnitude of an error source.
12. A method according to clause 11 wherein the respective weighting per subset of model parameters is determined in dependence of a ratio of a magnitude and/or impact of one or more process impact errors with respect to a magnitude and/or impact of one or more exposure errors.
13. A method according to any preceding clause, wherein the respective weighing per subset of model parameters is determined by simulating the resulting a performance indicator for different weight combinations and selecting the weighting which optimizes the performance indicator.
14. A method according to clause 13, wherein said performance indicator comprises overlay performance.
15. A method according to any preceding clause, wherein said combined alignment model is used for determining positional corrections for the exposure of the third layer.
16. A method according to clause 15, comprising exposing the third layer in accordance with the positional corrections.
17. A method according to any preceding clause, wherein said determining a respective weighting step comprises determining a respective weighting respectively for different common subsets of model parameters comprised within said first alignment model and second alignment model.
18. A method according to any preceding clause, comprising measuring first alignment marks in said first layer to obtain first layer alignment data and measuring second alignment marks in said second layer to obtain the second layer alignment data.
19. A method according to clause 18, wherein said second alignment marks do not overlap with said first alignment marks.
20. A method according to clause 18 or 19, wherein said first alignment marks and second alignment marks are arranged in adjacent pairs of alignment marks, each adjacent pair comprising one of said first alignment marks positioned substantially adjacent to one of said second alignment marks.
21. A method according to any of clauses 18 to 20, wherein said measuring steps comprising measuring one or more of said adjacent pairs of alignment marks in the same scan direction.
22. A computer program comprising program instructions operable to perform the method of any preceding clause, when run on a suitable apparatus.
23. A non-transient computer program carrier comprising the computer program of clause 22.
24. A processing arrangement comprising: the non-transient computer program carrier of clause 23; and a processor operable to run the computer program comprised on said non-transient computer program carrier.
25. An exposure apparatus comprising: a patterning device support for supporting a patterning device; a substrate support for supporting a substrate; and a processing arrangement according to clause 24.
26. An exposure apparatus according to clause 25, further comprising an alignment sensor operable to measure the substrate to obtain at least said first layer metrology data and said second layer metrology data.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method for modeling alignment data for exposure of a third layer on a substrate in an exposure process, the method comprising:
obtaining at least first layer alignment data relating to a first layer and second layer alignment data relating to a second layer;
fitting a first model to the first layer alignment data to obtain a first alignment model and fitting a second model to the second layer alignment data to obtain a second alignment model;
determining, for each of a plurality of different subsets of model parameters of said first alignment model and second alignment model, a respective weighting for each of said first model and second model; and
combining the first model and second model in accordance with said weighting to determine a combined alignment model.

2. A method as claimed in claim 1, wherein the first layer comprises a layer with respect to which the second layer was aligned to when it was exposed.

3. A method as claimed in claim 1 or 2, wherein the second layer comprises a layer with respect to which overlay is critical for the third layer.

4. A method as claimed in claim 1, 2 or 3 wherein the second layer comprises the layer last exposed prior to exposure of the third layer.

5. A method as claimed in any preceding claim, wherein the plurality of subsets of model parameters comprises different model order subsets each said model order subset comprising model parameters of a respective different model orders or groups of model orders.

6. A method as claimed in claim 5, wherein a first subset of said plurality of subsets of model parameters comprises linear model parameters and at least a second subset comprises higher order model parameters of one or more higher model orders.

7. A method as claimed in any preceding claim, wherein said plurality of subsets of model parameters comprises one or more inter-region subsets and one or more intra-region subsets of model parameters.

8. A method as claimed in any preceding claim, wherein said plurality of subsets of model parameters comprises one or more interfield subsets and one or more intrafield subsets of model parameters.

9. A method as claimed in any preceding claim, wherein said plurality of subsets of model parameters comprises a first subset comprising interfield first order model parameters, a second subset comprising interfield higher order model parameter and a third subset comprising intrafield model parameters.

10. A method as claimed in any preceding claim, wherein one or more subsets of said plurality of subsets of model parameters comprises only a respective different single model parameter.

11. A method as claimed in any preceding claim, wherein the respective weighting per subset of model parameters is determined in dependence on an error source and/or a magnitude of an error source.

12. A method as claimed in claim 11 wherein the respective weighting per subset of model parameters is determined in dependence of a ratio of a magnitude and/or impact of one or more process impact errors with respect to a magnitude and/or impact of one or more exposure errors.

13. A method as claimed in any preceding claim, wherein the respective weighing per subset of model parameters is determined by simulating the resulting a performance indicator for different weight combinations and selecting the weighting which optimizes the performance indicator.

14. A method as claimed in any preceding claim, wherein said determining a respective weighting step comprises determining a respective weighting respectively for different common subsets of model parameters comprised within said first alignment model and second alignment model.

15. A computer program comprising program instructions operable to perform the method of any preceding claim, when run on a suitable apparatus.
